# EUROPÄISCHE PATENTANMELDUNG

(11) **EP 1 965 495 A2**
(43) Veröffentlichungstag der Anmeldung: **03.09.2008**
(21) Anmeldenummer: 08101536.4
(22) Anmeldetag: 12.02.2008
(51) Int. Cl.: H03K 19/007

(54) **Verfahren und Schaltungsanordnung zur Ansteuerung zumindest eines Transistors einer Treiberschaltungsanordnung**

(30) Priorität: 27.02.2007 DE 102007009547
(71) Anmelder: Continental Automotive GmbH, 30165 Hannover (DE)
(72) Erfinder: Kellner, Jürgen, 93059 Regensburg (DE)

(57) **Zusammenfassung**

Die Erfindung betrifft ein Verfahren zur Ansteuerung zumindest eines Transistors (2) einer Treiberschaltungsanordnung (1), insbesondere einer Low-Side-Treiberstufe, wobei an der Treiberschaltungsanordnung (1) zumindest ein erstes und zweites Spannungspotential (P1, P2) anliegen und der zumindest eine Transistor (2) durch Anlegen zumindest einer Ansteuersteuerspannung (as) geschaltet wird. Vorteilhaft wird die Ansteuerspannung (as) durch eine logische UND-Verknüpfung einer ersten Hilfsansteuerspannung (has1) und einer zweiten Hilfsansteuerspannung (has2) erzeugt, wobei die Amplitude der ersten oder der zweiten Hilfsansteuerspannung (has1, has2) vor der logischen UND-Verknüpfung dieser invertiert wird.

## Beschreibung

Die Erfindung betrifft ein Verfahren und eine Schaltungsanordnung zur Ansteuerung zumindest eines Transistors einer Treiberschaltungsanordnung gemäß dem Oberbegriff des Patentanspruches 1 und 5.

Schaltungsanordnungen, insbesondere Treiberschaltungsanordnung zur Ansteuerung von elektronischen Transistoren sind hinreichend bekannt.

Insbesondere im Automobilbereich werden zur Ansteuerung von Relaisschaltkreisen in den Steuergeräten so genannte Treiberstufen, insbesondere "Low Side" (LS) Treiberstufen bzw. Treiberverstärkungsanordnungen verwendet. Diese umfassen zumindest einen Transistor unterschiedlichster Bauart, mittels dem ein Schaltsignal erzeugt wird und abhängig davon beispielsweise ein Relaisschaltkreis geschaltet wird. Ein derartiger Relaisschaltkreis kann beispielsweise zur Ansteuerung des Verriegelungssystems eines Fahrzeuges vorgesehen sein. Ein Schalten des Relaisschaltkreises würde hierbei zu einer vollständigen Verriegelung eines Fahrzeuges führen, wobei eine Entriegelung weder von Innen noch von Außen mehr möglich ist. Derartige Funktionen sind beispielsweise unter den Bezeichnungen "doublelocking", "deadlocking" oder "superlocking" bekannt.

Ferner werden für im Fahrzeug vorgesehene elektronische Schaltkreise so genannte "Unterwassertests" gefordert. Im Rahmen dessen wird das Steuergerät in ein Wasserbad getaucht und die Störungsempfindlichkeit der Schaltungsanordnung bestimmt wird. Im Rahmen des Unterwassertests dürfen beispielsweise keine Störungen der Fahrzeugfunktionen auftreten, welche das Leben der Fahrzeuginsassen gefährden könnten. Beispielsweise können durch den Kontakt mit Wasser Kurzschlüsse zwischen den Anschlüssen einzelner elektronischer Bauteile, insbesondere den Anschlüssen eines Transistors einer Schaltungsanordnung erzeugt werden, welche mit dem Anlegen einer Schaltspannung an zumindest zwei Anschlüssen eines Transistors gleichzusetzen sind. Insbesondere kann abhängig von der Bauart des Transistors eine an den Basis/Kollektor- bzw. Basis/Emitter-Eingängen anliegende Spannung zu einem unbeabsichtigten "Durchschalten" des Transistors führen. Durch das unbeabsichtigte Schalten des Transistors wird ein Schaltsignal erzeugt, welches ggf. einen Relaisschaltkreis aktiviert, der beispielsweise eine "deadlock", "doublelocking" oder "superlocking" Funktion auslöst. Durch die beschriebenen Funktionen wird das Fahrzeug vollständig verriegelt und abhängig von den vorherrschenden Umweltbedingungen ggf. eine maßgebliche Gefährdung des Leben der Insassen hervorgerufen.

Bisher werden zur Vermeidung derartiger Kurzschlüsse der in den Schaltungsanordnungen verwendeten Transistoren Treiberschaltungsanordnungen mit Serial-Peripheral-Interface (SPI) Ansteuerung vorgesehen, bei denen keine Kurzschlüsse der Transistoranschlüsse auftreten können. Nachteilig sind derartige Treiberschaltung mit SPI-Ansteuerung jedoch kostenintensiv.

Ausgehend vom geschilderten Stand der Technik liegt der Erfindung die Aufgabe zugrunde, ein Verfahren und eine Schaltungsanordnung zur Ansteuerung zumindest eines Transistors anzugeben, welche die aus dem Stand der Technik bekannten Nachteile vermeidet.

Die Aufgabe wird jeweils ausgehend vom Oberbegriff des unabhängigen Patentanspruches 1 und 5 durch dessen kennzeichnende Merkmale gelöst. Vorteilhafte Ausbildungen der Erfindung sind den weiteren abhängigen Ansprüchen zu entnehmen.

Der wesentliche Aspekt des erfindungsgemäßen Verfahrens bzw. Schaltungsanordnung ist darin zu sehen, dass die Ansteuerspannung durch eine logische UND-Verknüpfung einer ersten Hilfsansteuerspannung und einer zweiten Hilfsansteuerspannung erzeugt wird, wobei die Amplitude der ersten oder der zweiten Hilfsansteuerspannung vor der logischen UND-Verknüpfung dieser invertiert wird. Mittels der eine erfindungsgemäßen logische Verknüpfung eines ersten und zweiten Hilfsansteuersignals und somit einer redundanten Auslegung kann ein ungewolltes Schalten derartiger Treibertransistoren bei eindringenden Wasser verhindert werden. Das beschriebene Sicherheitskonzept ist kostengünstig realisierbar.

In einer weiteren vorteilhaften Ausführungsform werden die Amplitude der ersten Hilfsansteuerspannung logisch High und die Amplitude der zweiten Hilfsansteuerspannung logisch Low oder vice versa gewählt. Neben einer an der Treiberschaltungsanordnung anliegenden Versorgungsspannung und dem Erdpotential wird durch die erfindungsgemäße UND-Verknüpfung eines High-Signals und eines inversen Low-Signals sichergestellt, dass auch bei aufgrund des eindringenden Wassers entstehenden Kurzschlüssen auf der Schaltungsanordnung ein ungewolltes Schalten des Transistors unterbunden wird.

Besonders vorteilhaft ist das beschriebene Verfahren auch in einem integrierten Schaltkreis implementierbar. Hierbei sind die Anschlüsse ("Pins") bzw. Eingänge des integrierten Schaltkreises zur Zuführung der ersten und zweiten Hilfsansteuerspannung bzw. des ersten und zweiten Spannungspotentials derart angeordnet, dass jeweils zwei invertierte Spannungspotentiale an einer Seite des Gehäuses des integrierten Schaltkreises anliegen einen maximalen Abstand auf.

Im Folgenden wird die Erfindung an einem Ausführungsbeispiel anhand von Zeichnungen näher erläutert.

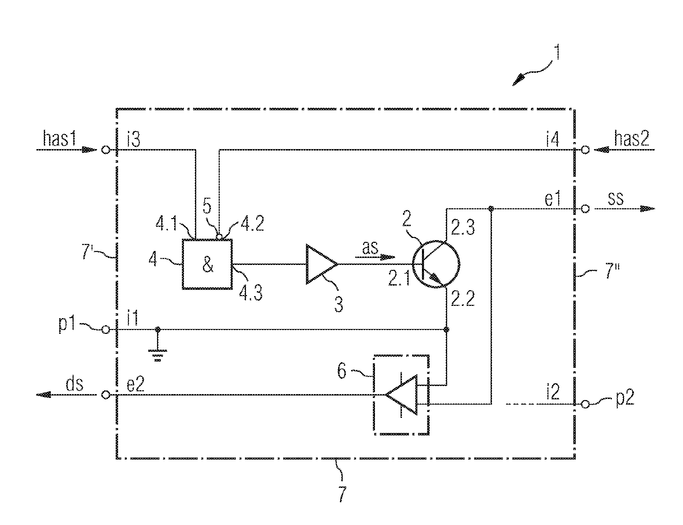

In der Figur ist beispielhaft in einem schematischen Blockschaltbild eine Treiberschaltungsanordnung 1 dargestellt, welche einen Transistor 2 aufweist. In einer bevorzugten Ausführungsform ist die Treiberschaltungsanordnung 1 als Low-Side-Treiberstufe ausgebildet.

Die Treiberschaltungsanordnung 1 weist einen ersten bis vierten Eingang i1 bis i4 sowie einen ersten und zweiten Ausgang e1, e2 auf, wobei am ersten Eingang i1 ein erstes Spannungspotential p1, vorzugsweise das Erdpotential und am zweiten Eingang i2 ein zweites Spannungspotential p2, vorzugsweise die Versorgungsspannung anliegt. Die Versorgungsspannung p2 ist hierbei zur Spannungsversorgung von weiteren, nicht in der Figur dargestellten elektronischen Bauteilen der Treiberschaltungsanordnung 1 vorgesehen.

Neben dem Transistor 2 umfasst die Treiberschaltungsanordnung 1 beispielsweise ein elektronisches Pufferbauelement 3, ein logisches UND-Gatter 4, einen Inverter 5 sowie eine Diagnoseschaltung 6. Die Treiberschaltungsanordnung 1 ist beispielsweise in ein Gehäuse 7 integriert, welches in der Figur mittels einer strichliert gezeichneten Linie angedeutet ist.

Der Transistor 2 weist beispielsweise einen Basisanschluss 2.1, einen Emitteranschluss 2.2 sowie einen Kollektoranschluss 2.3 auf. Ferner weist das logische UND-Gatter 4 einen ersten und zweiten Eingang 4.1, 4.2 sowie einen Ausgang 4.3 auf. Der erste Eingang 4.1 ist mit dem dritten Eingang i3 der Transistorschaltungsanordnung 1 und der zweite Eingang 4.2 des logischen UND-Gatters 4 ist über den Inverter 5 mit dem vierten Eingang i4 der Transistorschaltungsanordnung 1 verbunden. Ferner ist der Ausgang 4.3 des logischen UND-Gatters 4 über das elektronische Pufferbauelement 3 an den Basisanschluss 2.1 des Transistors 2 geführt.

An den Basisanschluss 2.1 des Transistors 2 wird eine durch das logische UND-Gatter 4 erzeugte und mittels des elektronischen Pufferbauelement 3 kurzzeitig gespeicherte Ansteuerspannung as angelegt, welche ein Durchschalten des Transistors 2 bewirkt.

Im vorliegenden Ausführungsbeispiel wird der Transistor 2 beispielsweise in Emitterschaltung betrieben, d.h. der Emitteranschluss 2.2 des Transistors 2 ist mit dem Erdpotential und der Kollektoranschluss 2.3 beispielsweise mit dem zweiten Spannungspotential P2 verbunden. Bei Anliegen des Ansteuerspannung as am Basisanschluss 2.1 des Transistors 2 wird durch diesen am Kollektoranschluss 4.3 eine Schaltspannung ss erzeugt und an den ersten Ausgang e1 der Transistorschaltungsanordnung 1 geführt. Durch die erzeugte Schaltspannung ss wird beispielsweise eine Relaisschaltung angesteuert. In einer bevorzugten Ausführungsform übernimmt der Transistors 2 die Funktion eines "Schalters", d.h. befindet sich im Nicht-Schaltzustand im "Open-Kollektor-Betrieb". Bei Anlegen der Ansteuerspannung as wird der Kollektoranschluss 4.3 mit dem ersten Spannungspotential p1, vorzugsweise dem Erdpotential verbunden.

Erfindungsgemäß wird die Ansteuerspannung as durch eine logische UND-Verknüpfung mittels des UND-Gatters 4 einer ersten Hilfsansteuerspannung has1 und einer zweiten Hilfsansteuerspannung has2 erzeugt, welche vorzugsweise am ersten bzw. zweiten Eingang 4.1, 4.2 des logischen UND-Gatters 4 anliegen. Hierbei wird die Amplitude der zweiten Hilfsansteuerspannung has2 vor der logischen UND-Verknüpfung mittels des Inverters 5 invertiert. Die Amplitude der ersten Hilfsansteuerspannung has1 entspricht beispielsweise einem logischen "High" bzw. "1", wohingegen die Amplitude der zweiten Hilfsansteuerspannung has2 ein logisches "Low" bzw. "0" aufweist. Alternativ kann die Amplitude der ersten Hilfsansteuerspannung has1 beispielsweise einem logischen "Low" bzw. "0" entsprechen und die Amplitude der zweiten Hilfsansteuerspannung has2 ein logisches "High" bzw. "1" aufweisen. Hierdurch ergibt sich ein fehlerresistente redundante Erzeugung der Ansteuerspannung as zum Schalten des Transistors 2, d.h. ein Sicherheitskonzept, bei dem selbst bei Auftreten von durch eindringendes Wasser hervorgerufenen Kurzschlüssen von Spannungspotentialen der Treiberschaltungsanordnung 1 kein ungewolltes Schalten des Transistors 2 ausgelöst wird.

In einer besonders bevorzugten Ausführungsform weist die Treiberschaltungsanordnung 1 die Diagnoseschaltung 6 auf, welche ein Diagnosespannung ds liefert. Die Diagnosespannung ds entspricht hierbei beispielsweise der Differenz zwischen der Schaltspannung ss und dem ersten Spannungspotential P1. Hierbei wird mittels der Diagnosespannung anzeigt, ob eine ordnungsgemäße Funktion der Treiberschaltungsanordnung 1 vorliegt.

Die Treiberschaltungsanordnung 1 kann als integrierte Schaltungsanordnung, insbesondere als Application Specific Integrated Circuit (ASIC) ausgebildet sein.

Die zur Zuführung der ersten und zweiten Hilfsansteuerspannung has1, has2 bzw. des ersten und zweiten Spannungspotentials p1, p2 vorgesehenen Eingänge i1 bis i4 bzw. die entsprechenden Anschlüsse ("Pins") der integrierten Schaltungsanordnung sind hierbei derart am Gehäuse 7 angeordnet, dass jeweils zwei invertierte Spannungspotentiale an einer Seite des Gehäuses 7 anliegen, d.h. der das erste Spannungspotential p1 ("Erdpotential") aufnehmende erste Eingang i1 und der die erste Hilfsansteuerspannung has1 ("logisches High Signal") aufnehmende dritte Eingang i3 sind an einer ersten Gehäuseseite 1' und der das zweite Spannungspotential p2 ("Batterie- oder Versorgungsspannung") aufnehmende zweite Eingang i2 und der die zweite Hilfsansteuerspannung has2 ("logisches Low Signal") aufnehmende vierte Eingang i3 sind an einer gegenüberliegenden zweiten Gehäuseseite 1" angeordnet.

Die Erfindung wurde voranstehend an einem Ausführungsbeispiel beschrieben. Es versteht sich, dass zahlreiche Änderungen und Modifikationen möglich sind, ohne dass das der Erfindung zugrunde liegende Gedanke verlassen wird.

### Bezugszeichenliste

- 1: Treiberschaltungsanordnung
- 2: Transistor
- 2.1: Basisanschluss
- 2.2: Emitteranschluss
- 2.3: Kollektoranschluss
- 3: elektronisches Pufferbauelement
- 4: logisches UND-Gatter
- 4.1: erster Eingang
- 4.2: zweiter Eingang
- 4.3: Ausgang
- 5: Inverter
- 6: Diagnoseschaltung
- 7: Gehäuse
- 7': erste Gehäuseseite
- 7'': zweite Gehäuseseite

- i1 - i4: erster bis vierter Eingang
- e1, e2: erster und zweiter Ausgang
- p1: erstes Spannungspotential
- p2: zweites Spannungspotential
- has1: erste Hilfsansteuerspannung
- has2: zweite Hilfsansteuerspannung
- as: Ansteuerspannung
- ss: Schaltspannung
- ds: Diagnosespannung

## Patentansprüche

1. Verfahren zur Ansteuerung zumindest eines Transistors (2) einer Treiberschaltungsanordnung (1), insbesondere einer Low-Side-Treiberstufe, wobei an der Treiberschaltungsanordnung (1) zumindest ein erstes und zweites Spannungspotential (P1, P2) anliegen und der zumindest eine Transistor (2) durch Anlegen zumindest einer Ansteuersteuerspannung (as) geschaltet wird,
**dadurch gekennzeichnet,**
**dass** die Ansteuerspannung (as) durch eine logische UND-Verknüpfung einer ersten Hilfsansteuerspannung (has1) und einer zweiten Hilfsansteuerspannung (has2) erzeugt wird, wobei die Amplitude der ersten oder der zweiten Hilfsansteuerspannung (has1,has2) vor der logischen UND-Verknüpfung dieser invertiert wird.

2. Verfahren nach Anspruch 1,
**dadurch gekennzeichnet,**
**dass** die Amplitude der ersten Hilfsansteuerspannung (has1) logisch High und die Amplitude der zweiten Hilfsansteuerspannung (has2) logisch Low oder vice versa gewählt werden.

3. Verfahren nach Anspruch 1 oder 2,
**dadurch gekennzeichnet,**
**dass** das erste Spannungspotential (p1) durch das Erdpotential und das zweite Spannungspotential (p2) durch eine Versorgungsspannung gebildet werden.

4. Verfahren nach einem der vorhergehenden Ansprüche,
**dadurch gekennzeichnet,**
**dass** der zumindest eine Transistor (2) in Emitterschaltung betrieben wird.

5. Schaltungsanordnung bestehend aus zumindest einem Transistor (2) mit einem Basis-, Emitter- und Kollektoranschluss (2.1, 2.2, 2.3), zumindest einem logischen UND-Gatter (4) mit einem ersten und zweiten Eingang (4.1, 4.2) und einem Ausgang (4.3) und einem Inverter (5), wobei an der Schaltungsanordnung (1) zumindest ein erstes und zweites Spannungspotential (p1, p2) anliegen,
**dadurch gekennzeichnet,**
**dass** der Ausgang (4.3) des logischen UND-Gatters (4) mit dem Basisanschluss (2.1) des Transistors (2) verbunden ist,
**dass** am ersten Eingang (4.1) des logischen UND-Gatters (4) eine erste Hilfsansteuerspannung (has1) und am zweiten Eingang (4.2) des logischen UND-Gatters (4) eine mittels dem Inverter (5) invertierte zweite Hilfsansteuerspannung (has2) oder vice versa anliegen, wodurch am Ausgang (4.3) des logischen UND-Gatters (4) eine Ansteuerspannung (as) zum Schalten des Transistors (2) erzeugt wird.

6. Schaltungsanordnung nach Anspruch 5,
**dadurch gekennzeichnet,**
**dass** die Amplitude der ersten Hilfsansteuerspannung (has1) ein logisches "High" und die Amplitude der zweiten Hilfsansteuerspannung (has2) ein logisches "Low" oder vice versa aufweist.

7. Schaltungsanordnung nach Anspruch 5 oder 6,
**dadurch gekennzeichnet,**
**dass** das erste Spannungspotential (p1) dem Erdpotential und das zweite Spannungspotential (p2) einer Versorgungsspannung entsprechen.

8. Schaltungsanordnung nach einem der Ansprüche 5 bis 7,
**dadurch gekennzeichnet,**
**dass** die Schaltungsanordnung (1) als integrierte Schaltungsanordnung, insbesondere als Application Specific Integrated Circuit ausgebildet ist.

9. Schaltungsanordnung nach Anspruch 8,
**dadurch gekennzeichnet,**
**dass** die zur Zuführung der ersten und zweiten Hilfsansteuerspannung (has1, has2) und des ersten und zweiten Spannungspotentials (p1 ,p2) vorgesehenen Eingänge (i1, i2, i3, i4) der integrierten Schaltungsanordnung (1) derart zueinander angeordnet sind, dass jeweils zwei invertierte Spannungspotentiale (has1, has2, p1, p2) an einer Seite des integrierten Schaltkreises anliegen.
